(19) Europäisches Patentamt
European Patent Office
Office européen des brevets

(11) Publication number: **0 334 961 B1**

(12) # EUROPEAN PATENT SPECIFICATION

(45) Date of publication of patent specification: **10.02.93**

(51) Int. Cl.5: **C04B 35/64**, C04B 35/00, H01L 39/24

(21) Application number: **88907794.7**

(22) Date of filing: **31.08.88**

(86) International application number: **PCT/JP88/00871**

(87) International publication number: **WO 89/01924 (09.03.89 89/06)**

(54) **PROCESS FOR FABRICATING SUPERCONDUCTING CERAMICS MATERIALS.**

(30) Priority: **31.08.87 JP 217191/87**

(43) Date of publication of application: **04.10.89 Bulletin 89/40**

(45) Publication of the grant of the patent: **10.02.93 Bulletin 93/06**

(84) Designated Contracting States: **DE FR GB**

(56) References cited:

**Materials Letters, volume 5, no. 10, September 1987, Elsevier Science Publishers B.V. (North-Holland Physics Publishing Division), (Amsterdam, NL), H. Oesterreicher: "Synthesis of YBa2Cu3Ox under O2 pressure and its superconductivity", pages 391-392, see page 391, paragraphs 2, 3**

**Advanced Ceramics Materials- Ceramic Superconductors, volume 2, no. 3B, July 1987, ACers, (Westerville, Ohio, US), H.M. O'Bryan et al.: "Characterization of Ba2YCu3Ox as a function of oxygen partial pressure ; part II depemdemce of the O-T transition on oxygen content", pages 640-648, see page 640, paragraph 2 - page 641, paragraph 5**

(73) Proprietor: **MITSUBISHI MATERIALS CORPORATION**
**6-1, Otemachi 1-chome**
**Chiyoda-ku Tokyo(JP)**

(72) Inventor: **TAKESHITA, Takuo**
**149-404, Kishikicho 3-chome**
**Omiya-shi Saitama 330(JP)**
Inventor: **HAGINO, Sadaaki**
**7-203, 33-8, Harayama 2-chome**
**Urawa-shi Saitama 336(JP)**

(74) Representative: **Andrae, Steffen, Dr. et al**
**Patentanwälte Andrae, Flach, Haug, Kneissl**
**Balanstrasse 55**
**W-8000 München 90(DE)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

EP 0 334 961 B1

## Description

### Technical Field

The present invention relates to a process for fabricating superconducting ceramics materials comprising an yttrium-including rare earth element, an alkaline earth metal and copper oxide (hereinafter referred to as "R-A-Cu-O based ceramics") which has a high theoretical density ratio and thus has a high critical current value.

### Background Art

Conventional processes for fabricating worked materials such as wire rods, plates, strings, coils, and ribbons made of an R-A-Cu-O based superconducting ceramics include a process in which starting powders, i.e., an $R_2O_3$ powder, an alkaline earth metal carbonate powder, and a CuO powder, each having an average grain size of not greater than 10 µm, are provided and compounded in a predetermined compounding ratio followed by mixing to obtain a mixed powder, which is then calcined, e.g., in an atmosphere of dry air or an oxygen atmosphere of 1 bar (1 atm) at a temperature of from 930 °C to 950 °C for a retention time of 5 hours to form a ceramics material having a composition of $YBa_2Cu_3O_7$ and having a perovskite structure, for example, the ceramics is then ground to obtain ponder of an average grain size of from 0.4 µm to 10 µm and applied molding force of from 98 to 196 MPa (1 to 2 ton/cm$^2$) to obtain a molded body, the molded body is sintered in an electric furnace in an atmosphere of 1 bar (1 atm), at a temperature of from 900 °C to 950 °C for a retention time of 12 hours and then cooled in the furnace and heat-treated in an oxygen flow of 1 bar (1 atm), at a temperature of from 500 °C to 600 °C for a retention time of from 2 to 5 hours to obtain a superconducting ceramics having a composition substantially the same as that of the ceramics as above described.

In: Materials Letters, Vol. 5, No. 10, September 1987, Elsevier Science Publishers B.V., H. Oesterreicher, pages 391-392, there is disclosed a heating procedure which could e.g. be conducted in the the conventional sintering atmosphere air, wherein the partial pressure of oxygen is 0.21 bar (0.209 atm).

With the above-described conventional processes, the superconducting ceramics having high density and thus high mechanical strength is obtained when the molded body is sintered in an oxygen-poor atmosphere with partial pressure of oxygen being low. In other words, the lower the partial pressure of oxygen, the higher the density of the superconducting ceramics. However, the resulting superconducting ceramics tends to lack oxygen because the atmosphere of sintering is poor in oxygen. For example, when fabrication of $YBa_2Cu_3O_7$ is contemplated, the product has a composition of $YBa_2Cu_3O_{7-d}$ where $\underline{d}$ indicates the degree of deficiency of oxygen. This causes deterioration of the superconducting characteristics such as high critical current value and high critical temperature of worked superconducting ceramics materials.

### Disclosure of Invention

An object of the present invention is to obviate defects of the conventional processes and provide a process for fabricating worked superconducting ceramics materials having high density and high mechanical strength, in addition to having high critical current value and high critical temperature.

As a result of extensive investigation, it has now been found that sintering of superconducting ceramics powder in two steps with different partial pressures of oxygen gives rise to superconducting ceramics material having a high density and an excellent superconducting characteristics.

Therefore, the present invention provides a process for fabricating worked superconducting ceramics material composed essentially of an yttrium-including rare earth element, an alkaline earth metal, copper and balance oxygen and unavoidable impurities, comprising:

(A) providing a starting powder composed of:

(i) a member selected from the group consisting of:

(1) a mixed powder composed of powders of component oxides:

(1-1) an yttrium-including rare earth element oxide,

(1-2) an alkaline earth metal oxide, and

(1-3) copper oxide,

and having a composition substantially the same as that of a contemplated superconducting ceramics,

(2) a mixed powder composed of powders of:

(2-1) a partial compound between any two of the component oxides constituting a contemplated

superconductive ceramics selected from (1-1), (1-2) and (1-3), and

(2-2) the rest of the component oxides selected from (1-1), (1-2) and (1-3),

and having a composition substantially the same as that of a contemplated superconducting ceramics,

(3) powder of a superconducting ceramics composed essentially of an yttrium-including rare earth element, an alkaline earth metal, copper and balance oxygen and unavoidable impurities,

(4) a mixed powder composed of at least two members selected from the mixed powders (1), (2) and (3); and

(B) molding the starting powder to form a molded body;

(C) optionally calcining the starting powder when the starting powder is the mixed powder (i)-(1), (i)-(2) or (i)-(4) at a temperature sufficient for calcining the starting powder prior to or after molding;

(D) sintering the molded body in an oxygen-poor atmosphere having a partial pressure of oxygen of 10 to $10^{-7}$ mbar ($10^{-2}$ to $10^{-10}$ atm); and

(E) heat-treating the sintered molded body in an oxygen-rich atmosphere having a partial pressure of oxygen above 1 bar (1 atm).

Best Mode for Carrying Out the Invention

Hereinafter, description will be made on a typical embodiment of the present invention, in which the starting powder for fabricating superconducting ceramics material is powder of a superconducting ceramics (R-A-Cu-O) composed essentially of an yttrium-including rare earth element (R), an alkaline earth metal (A), copper (Cu), and balance oxygen (O) and unavoidable impurities.

Suitable examples of the yttrium-including rare earth element which can be used include yttrium (Y), erbium (Er), dysprosium (Dy), ytterbium (Yb), gadolinium (Gd), thulium (Tm), neodymium (Nd), (Lu), and samarium (Sm). Of these, yttrium is preferred. The yttrium-including rare earth elements can be used singly or in combination.

Suitable examples of the alkaline earth metal which can be used in the present invention include barium, strontium and calcium, with barium being preferred. The alkaline earth metal can be used singly or in combination.

Powder of superconducting ceramics which can be used as a starting powder in the process of the present invention can be prepared, e.g., by calcining a mixture of single component oxides with a composition substantially the same as that of a contemplated superconducting ceramics material in an oven, e.g., electric oven at a temperature suitable for preparing ceramics, e.g., 350 °C to 950 °C, and grinding the resulting superconducting ceramics material to have a desired mean grain size, e.g., not greater than 10 μm. Generally, smaller mean grain size, e.g., not greater than about 6 μm, is preferred. Of course, it is possible to use superconducting ceramics material otherwise prepared as far as it has a composition of R-A-Cu-O, e.g., $YBa_2Cu_3O_7$, to be fabricated after grinding, if desired. The superconducting ceramics powder may preferably have perovskite structure. Examples of known ceramics include those described, e.g., in Tomoji Kawai and Masaki Kanai, Japanese Journal of Applied Physics, vol. 26, No. 5, May, 1987, pp.L736-L737; and Masanobu Kobayashi et al., ibid. pp.L754-L756.

The starting powder is subjected to a molding treatment such as pressing and the like to obtain a molded body in the form of pellets, films, sheets, etc. having a predetermined density. It is noted that "molding treatment" includes formation in pellets by pressing, film formation using a doctor's blade method, film formation by screen printing and the like.

Then, the molded body is sintered in an oxygen-poor atmosphere with the partial pressure of oxygen being from 10 to $10^{-7}$ mbar ($10^{-2}$ to $10^{-10}$ atm), at a temperature (Ts) of from 870 °C to 950 °C for a retention time ranging from 4 to 12 hours. The sintering serves to increase the density of the sintered molded body so that it can have high mechanical strength.

Then, the molded body sintered in an oxygen-poor atmosphere are heat-treated in an oxygen-rich atmosphere with the partial pressure of oxygen being above 1 bar (1 atm) at a temperature (Th) of from 350 °C to 950 °C for a retention time ranging from 2 to 12 hours, thereby obtaining a superconducting ceramics material having an excellent superconducting characteristics and high mechanical strength. The heat-treatment serves to increase the oxygen content of the superconducting ceramics material without reducing the mechanical strength thereof. This is also useful for relieving or relaxing stress generated during molding and/working.

After molding, the molded body may be subjected to cold- or hot-working, e.g., swaging, rolling with grooved rolls, processing with a die, or the like, to produce a worked body having a desired shape, e.g.,

wire rods, plates, ribbons, strings, coils, pellets and the like. If appropriate or desired, the cold- or hot-working may be preformed after molding and optional calcination and prior to sintering.

In another typical embodiment of the present invention, the superconducting ceramics material can be fabricated starting from a mixture of powder of an yttrium-including rare earth element oxide ($R_2O_3$), powder of an alkaline earth metal oxide (AO) and powder of copper oxide (CuO). The composition of these single component oxides are blended so that the resulting mixture has a composition substantially the same as that of a final superconducting ceramics material.

Examples of the yttrium-including rare earth element oxide which can be used include oxides of yttrium-including rare earth elements. The same yttrium-including rare earth elements described above with respect to the preceding embodiment can also be used in the instant embodiment. Of the oxides, generally yttrium oxide is preferred. The yttrium-including rare earth elements can be used singly or in combination with each other.

Examples of the alkaline earth metal oxide which can be used in the present invention include oxides of barium, strontium and calcium. Barium oxide is preferred. The alkaline earth metal oxides can be used singly or in combination.

The single component oxides, i.e., powder of a rare earth element oxide, powder of an alkaline earth metal oxide and powder of copper oxide, each are commercially available. They can be used as they are or after being ground in order to adjust the mean grain size to a desired size. Usually, single component oxide powders to be used have a mean grain size of not greater than 10 $\mu$m. Generally, a smaller mean grain size, e.g., not greater than 6 $\mu$m, is preferred.

The calcination of the mixed powder composition, which may be prior to or after being subjected to molding treatment, can be performed at a predetermined temperature, preferably ranging from 850 °C to 950 °C, more preferably from 900 °C to 940 °C, in the air for a period sufficient to convert the mixed powder composition into a superconductive ceramics.

The same mold treatment as described with respect to the preceding embodiment can be used.

After the calcination and molding in this order or in reverse order, the resulting superconducting ceramics is then subjected to cold- or hot-working, which can be performed in the same manner as in the case of fabricating the superconducting ceramics material starting from the superconducting ceramics powder.

The molded bodies can be heat-treated and cooled in the same manner as in the case of one fabricated starting from the superconducting ceramics powder.

Further, according to a variation of the above-described embodiments, powder of partial compounds between any two of the component oxides for fabricating superconducting ceramics articles, i.e., a compound between the yttrium-including rare earth element and the alkaline earth metal oxide, a compound between the alkaline earth metal and copper oxide, and a compound between copper oxide and the yttrium-including rare earth element, can be used together with powder of the remainder of the component oxides, i.e., copper oxide, the yttrium-including rare earth element, and the alkaline earth metal, respectively, instead of using a mixture of powders of single component oxides alone as a starting powder. For example, Y-Ba-CuO based superconducting ceramics materials can be fabricated using $Y_2O_3 \cdot BaO$ and CuO in a composition substantially the same as that of the final ceramics. Other combinations such as $CuO \cdot BaO$, and $Y_2O_3 \cdot CuO$, together with $Y_2O_3$, and BaO, respectively, can also be used. Similarly, partial compounds can be used for ceramics compositions containing other yttrium-including rare earth elements.

The partial compounds between any two of the single component oxides for fabricating superconducting ceramics material can be commercially available or can be prepared in conventional manner, e.g., by calcining a mixture of powders of any two of the single component oxides described above in an oven at temperatures suitable for preparation of ceramics.

The ratio of powder of the partial compound to the remainder single component oxide which can be added is not critical as far as the resulting mixture has a composition substantially the same as that of a finally obtained superconducting ceramics material.

According to another variation, the mixed powder of the single component oxides, and/or the mixed powder of the partial compound and the remainder of the single component oxides, can be added to powder of the superconducting ceramics powder. In this case, the mixing ratio therebetween is not critical.

In the above-described variations, a superconducting ceramics material can be obtained with substantially the same operations including calcination, molding, sintering, heat-treating and cooling under substantially the same conditions as in the case of superconducting ceramics obtained starting from a mixture of powders of single component oxides, and detailed explanation is omitted herein.

The superconducting ceramics may be the same as those used in the above-described embodiments of this invention, and it may preferably have a perovskite structure.

On the other hand, it is noted that;

(1) A superconducting ceramics having a rhombic crystalline structure is stable in a high temperature region in an oxygen-rich atmosphere, and a tetragonal crystalline structure of the superconducting ceramics can be converted to the rhombic crystalline structure thereof with ease by increasing the content of oxygen in an atmosphere.

(2) The conversion of the superconducting ceramics from the tetragonal to the rhombic crystalline structure is easily accelerated in the high temperature region because the atomic diffusion rate in the ceramics becomes higher in the high temperature region in comparison with the rate at a temperature of not higher than the lowest temperature of the high temperature region.

Therefore, in a further variation, the lowest temperature of the high temperature region may preferably be a temperature of not lower than 300 °C, and the heat-treated ceramics may preferably be cooled at a cooling rate satisfying a relation expressed by the following equation:

$$\Delta T/\Delta t \leq T \cdot \sqrt{P_{O_2}}$$

wherein

T indicates the temperature (°C),

t indicates the cooling time (hour), and

$$P_{O_2}$$

indicates the partial pressure of oxygen (atm) in order to obtain a superconducting ceramics having excellent superconducting characteristics. The cooling serves to convert the crystalline structure of the superconducting ceramics from tetragonal to rhombic. The reason why the lowest temperature of the high temperature region is not lower than 300°C is because even if the heat-treated ceramics is rapidly cooled from a temperature of not higher than 300°C, the resulting ceramics has superconducting characteristics sufficient for practical use. Any of the starting powders described above may be used in the process according to this variation.

## EXAMPLES

The present invention will be explained in greater detail with reference to the following examples, which should in no way be construed as limiting the present invention.

In tables, "rem." stands for "remainder".

### Example 1

Various starting powders composed of R-A-Cu-O based superconducting ceramics having mean grain sizes and compositions as shown in Tables 1a and 1b below were subjected to molding. The molding was performed by pressing at a pressure of about 98 MPa (1 ton/$cm^2$) to obtain a molded body. The molded body was calcined in an atmosphere of 1 bar (1 atm) at a temperature of 910 °C for a retention time of 30 hours, and then ground to obtain powders having an average grain size of 1.2 $\mu$m, and having a perovskite structure.

Further, the thus-obtained powders were subjected to molding to form a plurality of molded bodies in the form of pellets, each having an outer diameter of 2.0 mm and a height of 5 mm. These molded bodies were sintered under conditions as shown in Tables 1c and 1d below and then heat-treated under conditions as shown in Tables 1e and 1f below to obtain superconducting ceramics. Some molded bodies were subjected to cooling after the heat-treatment. The cooling was performed at a cooling rate as shown in Table 1f.

For comparison, the comparative superconducting ceramics were obtained by the same procedures as above except the conditions of the sintering and heat-treating.

The density ($\rho$s), critical temperature (Tc) and critical current (Jc) of the superconducting ceramics thus obtained were measured and the results obtained are shown in Tables 1e and 1f below.

From the results shown in Tables 1g and 1h, it can be seen that the superconducting ceramics

fabricated according to the process of the present invention, in which the partial pressure of oxygen when sintering was 10 to $10^{-10}$ mbar ($10^{-2}$ to $10^{-10}$ bar or atm) and the partial pressure of oxygen when heat-treating was 2 to 10 bar (2 to 10 atm), not only had high density but also had Tc and Jc values much higher than those of the comparative superconducting ceramics. Also, it can be seen that the superconducting ceramics fabricated according to the process of the present invention, including the step of cooling performed at the above-described cooling rate after the heat-treatment, had Jc values much higher than that of the superconducting ceramics according to the process of the present invention in which the heat-treatment under the above-described cooling conditions was not performed.

Table 1a

| Run No. | Starting Powder | | | | Mean Grain Size (µm) |
|---|---|---|---|---|---|
| | Composition (wt.%) | | | | |
| | R | A | Cu | O | |
| 1-1 | Y: 13.3 | Ba: 41.2 | 28.6 | rem. | 0.7 |
| 1-2 | Er: 22.5 | Ba: 36.9 | 25.6 | rem. | 2.4 |
| 1-3 | Dy: 22.0 | Ba: 37.1 | 25.8 | rem. | 3.1 |
| 1-4 | Yb: 23.1 | Ba: 36.6 | 25.4 | rem. | 2.5 |
| 1-5 | Gd: 21.4 | Ba: 37.4 | 26.0 | rem. | 3.7 |
| 1-6 | Tm: 22.6 | Ba: 36.8 | 25.5 | rem. | 3.2 |
| 1-7 | Nd: 20.0 | Ba: 38.1 | 26.5 | rem. | 4.2 |
| 1-8 | Lu: 23.3 | Ba: 36.5 | 25.3 | rem. | 3.7 |
| 1-9 | Sm: 20.7 | Ba: 37.7 | 26.2 | rem. | 3.5 |
| 1-10 | Y: 13.5 | Ba: 37.7<br>Sr: 2.7 | 29.0 | rem. | 4.1 |
| 1-11 | Lu: 23.5 | Ba: 35.1<br>Ca: 0.5 | 25.7 | rem. | 3.0 |
| 1-12 | Same as 1-1 above | | | | |
| 1-13 | Same as 1-2 above | | | | |
| 1-14 | Same as 1-3 above | | | | |
| 1-15 | Same as 1-4 above | | | | |
| 1-16 | Same as 1-5 above | | | | |
| 1-17 | Same as 1-6 above | | | | |
| 1-18 | Same as 1-7 above | | | | |
| 1-19 | Same as 1-8 above | | | | |
| 1-20 | Same as 1-9 above | | | | |
| 1-21 | Same as 1-10 above | | | | |
| 1-22 | Same as 1-11 above | | | | |

Table 1b

| Run No. | Starting Powder | | | | Mean Grain Size (μm) |
|---|---|---|---|---|---|
| | Composition (wt.%) | | | | |
| | R | A | Cu | O | |
| 1-23 | Same as 1-1 above | | | | |
| 1-24 | Same as 1-2 above | | | | |
| 1-25 | Same as 1-3 above | | | | |
| 1-26 | Same as 1-4 above | | | | |
| 1-27 | Same as 1-5 above | | | | |
| 1-28 | Same as 1-6 above | | | | |
| 1-29 | Same as 1-7 above | | | | |
| 1-30 | Same as 1-8 above | | | | |
| 1-31 | Same as 1-9 above | | | | |
| 1-32 | Same as 1-10 above | | | | |
| 1-33 | Same as 1-11 above | | | | |
| 1-34 | Same as 1-1 above | | | | |
| 1-35 | Same as 1-2 above | | | | |
| 1-36 | Same as 1-3 above | | | | |
| 1-37 | Same as 1-4 above | | | | |
| 1-38 | Same as 1-5 above | | | | |
| 1-39 | Same as 1-6 above | | | | |
| 1-40 | Same as 1-7 above | | | | |
| 1-41 | Same as 1-8 above | | | | |
| 1-42 | Same as 1-9 above | | | | |
| 1-43 | Same as 1-10 above | | | | |
| 1-44 | Same as 1-11 above | | | | |

Table 1c

Sintering

| Run No. | Partial Pressure of Oxygen ($P_{O_2}$, bar) | Sintering Temperature (Ts, °C) | Sintering Period (hour) |
|---|---|---|---|
| 1-1 | $10^{-5}$ | 930 | 10 |
| 1-2 | Same as 1-1 above | | |
| 1-3 | $10^{-7}$ | 940 | 10 |
| 1-4 | Same as 1-1 above | | |
| 1-5 | Same as 1-1 above | | |
| 1-6 | $10^{-5}$ | 940 | 10 |
| 1-7 | Same as 1-1 above | | |
| 1-8 | Same as 1-3 above | | |
| 1-9 | $10^{-9}$ | 930 | 10 |
| 1-10 | Same as 1-3 above | | |
| 1-11 | Same as 1-1 above | | |
| 1-12 | $10^{-3}$ | 930 | 10 |
| 1-13 | $10^{-2}$ | 930 | 10 |
| 1-14 | Same as 1-12 above | | |
| 1-15 | Same as 1-12 above | | |
| 1-16 | $10^{-3}$ | 940 | 10 |
| 1-17 | $10^{-2}$ | 940 | 10 |
| 1-18 | Same as 1-13 above | | |
| 1-19 | Same as 1-12 above | | |
| 1-20 | Same as 1-13 above | | |
| 1-21 | Same as 1-12 above | | |
| 1-22 | Same as 1-16 above | | |

Table 1d

Sintering

| Run No. | Partial Pressure of Oxygen ($P_{O_2}$, bar) | Sintering Temperature (Ts, °C) | Sintering Period (hour) |
|---|---|---|---|
| 1-23 | Same as 1-1 above | | |
| 1-24 | Same as 1-1 above | | |
| 1-25 | $10^{-7}$ | 930 | 10 |
| 1-26 | $10^{-3}$ | 920 | 10 |
| 1-27 | Same as 1-1 above | | |
| 1-28 | Same as 1-16 above | | |
| 1-29 | Same as 1-1 above | | |
| 1-30 | $10^{-7}$ | 920 | 10 |
| 1-31 | Same as 1-25 above | | |
| 1-32 | Same as 1-1 above | | |
| 1-33 | Same as 1-1 above | | |
| 1-34 | 0.2 | 930 | 10 |
| 1-35 | Same as 1-34 above | | |
| 1-36 | 0.2 | 940 | 10 |
| 1-37 | 1.0 | 930 | 10 |
| 1-38 | Same as 1-37 above | | |
| 1-39 | Same as 1-36 above | | |
| 1-40 | Same as 1-34 above | | |
| 1-41 | Same as 1-36 above | | |
| 1-42 | Same as 1-37 above | | |
| 1-43 | 1.0 | 940 | 10 |
| 1-44 | Same as 1-34 above | | |

Table 1e

Heat-Treating

| Run No. | Partial Pressure of Oxygen ($P_{O_2}$, bar) | Heat-Treating Temperature (Th, °C) | Heat-Treating Period (hour) |
|---|---|---|---|
| 1-1 | 5 | 930 | 3 |
| 1-2 | 2 | 880 | 10 |
| 1-3 | 2 | 880 | 5 |
| 1-4 | 10 | 900 | 3 |
| 1-5 | 5 | 900 | 5 |
| 1-6 | 2 | 920 | 10 |
| 1-7 | 10 | 930 | 5 |
| 1-8 | Same as 1-5 above | | |
| 1-9 | 2 | 900 | 10 |
| 1-10 | Same as 1-6 above | | |
| 1-11 | 5 | 930 | 10 |
| 1-12 | 5 | 920 | 5 |
| 1-13 | 5 | 920 | 3 |
| 1-14 | 2 | 910 | 3 |
| 1-15 | 2 | 900 | 3 |
| 1-16 | 2 | 920 | 5 |
| 1-17 | 2 | 910 | 10 |
| 1-18 | 10 | 910 | 10 |
| 1-19 | Same as 1-12 above | | |
| 1-20 | Same as 1-12 above | | |
| 1-21 | Same as 1-12 above | | |
| 1-22 | Same as 1-12 above | | |

Table 1f

| Run No. | Heat-Treating: Partial Pressure of Oxygen ($P_{O_2}$, bar) | Heat-Treating: Heat-Treating Temperature (Th, $^{o}C$) | Heat-Treating: Heat-Treating Period (hour) | Cooling: Cooling Rate ($\Delta T/\Delta t$, $^{o}C$/hr) |
|---|---|---|---|---|
| 1-23 | 5 | 930 | 10 | 2070 |
| 1-24 | 2 | 920 | 5 | 1300 |
| 1-25 | 10 | 910 | 10 | 2870 |
| 1-26 | 10 | 890 | 10 | 2810 |
| 1-27 | 2 | 890 | 10 | 1250 |
| 1-28 | 5 | 910 | 5 | 2030 |
| 1-29 | 5 | 900 | 5 | 2010 |
| 1-30 | 10 | 890 | 3 | 2810 |
| 1-31 | 2 | 880 | 3 | 1240 |
| 1-32 | 2 | 900 | 5 | 1270 |
| 1-33 | 5 | 900 | 5 | 2010 |
| 1-34 | 0.2 | 930 | 5 | - |
| 1-35 | 0.2 | 910 | 5 | - |
| 1-36 | 0.2 | 910 | 5 | - |
| 1-37 | 1.0 | 900 | 5 | - |
| 1-38 | Same as 1-37 above | | | |
| 1-39 | 0.2 | 880 | 5 | - |
| 1-40 | 1.0 | 900 | 10 | - |
| 1-41 | 1.0 | 920 | 10 | - |
| 1-42 | 1.0 | 920 | 5 | - |
| 1-43 | 0.2 | 930 | 5 | - |
| 1-44 | 0.2 | 930 | 10 | - |

Table 1g

| Characteristics of Superconducting Ceramics | | | |
|---|---|---|---|
| Run No. | Density ($\rho s$, $g/cm^3$) | Critical Temperature (Tc, °K) | Critical Current (Jc, $A/cm^2$) |
| 1-1 | 5.5 | 97 | 5200 |
| 1-2 | 5.4 | 91 | 4200 |
| 1-3 | 5.6 | 87 | 3700 |
| 1-4 | 5.4 | 89 | 4600 |
| 1-5 | 5.3 | 91 | 4000 |
| 1-6 | 5.6 | 90 | 3200 |
| 1-7 | 5.4 | 87 | 3900 |
| 1-8 | 5.5 | 90 | 4100 |
| 1-9 | 5.6 | 85 | 3600 |
| 1-10 | 5.4 | 92 | 4500 |
| 1-11 | 5.3 | 92 | 5100 |
| 1-12 | 5.4 | 96 | 4900 |
| 1-13 | 5.3 | 91 | 4600 |
| 1-14 | 5.4 | 87 | 3500 |
| 1-15 | 5.4 | 88 | 4300 |
| 1-16 | 5.2 | 90 | 3900 |
| 1-17 | 5.4 | 91 | 3300 |
| 1-18 | 5.2 | 88 | 3700 |
| 1-19 | 5.5 | 90 | 4000 |
| 1-20 | 5.5 | 85 | 3500 |
| 1-21 | 5.4 | 91 | 4200 |
| 1-22 | 5.3 | 91 | 4700 |

Table 1h

| Characteristics of Superconducting Ceramics | | | |
|---|---|---|---|
| Run No. | Density ($\rho s$, g/cm$^3$) | Critical Temperature (Tc, °K) | Critical Current (Jc, A/cm$^2$) |
| 1-23 | 5.6 | 97 | 6300 |
| 1-24 | 5.5 | 91 | 4700 |
| 1-25 | 5.5 | 88 | 4200 |
| 1-26 | 5.4 | 90 | 5600 |
| 1-27 | 5.3 | 90 | 4300 |
| 1-28 | 5.5 | 89 | 3700 |
| 1-29 | 5.4 | 88 | 4800 |
| 1-30 | 5.4 | 90 | 4400 |
| 1-31 | 5.5 | 84 | 4900 |
| 1-32 | 5.5 | 91 | 4600 |
| 1-33 | 5.3 | 91 | 5900 |
| 1-34 | 4.3 | 96 | 260 |
| 1-35 | 4.2 | 90 | 340 |
| 1-36 | 4.4 | 87 | 320 |
| 1-37 | 4.1 | 88 | 170 |
| 1-38 | 3.9 | 91 | 130 |
| 1-39 | 3.8 | 89 | 320 |
| 1-40 | 4.1 | 86 | 310 |
| 1-41 | 4.3 | 88 | 420 |
| 1-42 | 4.2 | 83 | 360 |
| 1-43 | 3.5 | 90 | 310 |
| 1-44 | 3.9 | 92 | 140 |

## Example 2

As starting powder, $R_2O_3$ powder, AO powder and CuO powder each having a predetermined mean grain size of from 0.5 to 10 µm were blended at a blend ratio shown in Table 2a below. The superconducting ceramics were fabricated from the starting powder as above described in the same manner as the process in Example 1 above except that additional cooling was performed.

In the steps of sintering and heat-treating, molded bodies in the form of pellets were sintered under conditions as shown in Table 2b below and then heat-treated under conditions as shown in Table 2c below to obtain superconducting ceramics.

For comparison, the comparative superconducting ceramics were obtained by the same procedures as above except different conditions of steps of the sintering and heat-treating were used.

The density ($\rho s$), critical temperature (Tc) and critical current (Jc) of the superconducting ceramics thus obtained were measured and the results obtained are shown in Table 2d below.

From the results shown in Table 2d, it can be seen that the superconducting ceramics fabricated according to the process of the present invention, in which the partial pressure of oxygen when sintering was $10^{-2}$ to $10^{-10}$ bar ($10^{-2}$ to $10^{-10}$ atm) and the partial pressure of oxygen when heat-treating was 2 to 10 bar (2 to 10 atm), had Jc values much higher than that of the comparative superconducting ceramics.

Table 2a

| Run No. | Starting Powder | | |
|---|---|---|---|
| | Composition (wt.%) | | |
| | $R_2O_3$ | AO | CuO |
| 2-1 | $Y_2O_3$: 17.15 | BaO: 46.59 | rem. |
| 2-2 | $Er_2O_3$: 25.97 | BaO: 41.63 | rem. |
| 2-3 | $Dy_2O_3$: 25.50 | BaO: 41.89 | rem. |
| 2-4 | $Yb_2O_3$: 26.54 | BaO: 41.32 | rem. |
| 2-5 | $Gd_2O_3$: 24.95 | BaO: 42.21 | rem. |
| 2-6 | $Tm_2O_3$: 26.13 | BaO: 41.55 | rem. |
| 2-7 | $Nd_2O_3$: 25.12 | BaO: 42.98 | rem. |
| 2-8 | $Lu_2O_3$: 26.73 | BaO: 41.21 | rem. |
| 2-9 | $Sm_2O_3$: 24.23 | BaO: 42.61 | rem. |
| 2-10 | $Y_2O_3$: 17.41 | BaO: 42.58<br>SrO: 3.20 | rem. |
| 2-11 | $Lu_2O_3$: 27.09 | BaO: 39.66<br>CaO: 0.76 | rem. |
| 2-12 | Same as 2-1 above | | |
| 2-13 | Same as 2-2 above | | |
| 2-14 | Same as 2-3 above | | |
| 2-15 | Same as 2-4 above | | |
| 2-16 | Same as 2-5 above | | |
| 2-17 | Same as 2-6 above | | |
| 2-18 | Same as 2-7 above | | |
| 2-19 | Same as 2-8 above | | |
| 2-20 | Same as 2-9 above | | |
| 2-21 | Same as 2-10 above | | |
| 2-22 | Same as 2-11 above | | |

Table 2b

Sintering

| Run No. | Partial Pressure of Oxygen ($P_{O_2}$, bar) | Sintering Temperature (Ts, °C) | Sintering Period (hour) |
|---|---|---|---|
| 2-1 | $10^{-5}$ | 930 | 10 |
| 2-2 | Same as 2-1 above | | |
| 2-3 | $10^{-7}$ | 930 | 10 |
| 2-4 | $10^{-3}$ | 920 | 10 |
| 2-5 | Same as 2-1 above | | |
| 2-6 | $10^{-5}$ | 940 | 10 |
| 2-7 | $10^{-3}$ | 930 | 10 |
| 2-8 | Same as 2-1 above | | |
| 2-9 | $10^{-9}$ | 930 | 10 |
| 2-10 | Same as 2-1 above | | |
| 2-11 | Same as 2-7 above | | |
| 2-12 | 0.2 | 930 | 10 |
| 2-13 | Same as 2-12 above | | |
| 2-14 | 0.2 | 940 | 10 |
| 2-15 | Same as 2-12 above | | |
| 2-16 | Same as 2-12 above | | |
| 2-17 | Same as 2-14 above | | |
| 2-18 | Same as 2-14 above | | |
| 2-19 | Same as 2-14 above | | |
| 2-20 | Same as 2-12 above | | |
| 2-21 | Same as 2-14 above | | |
| 2-22 | Same as 2-12 above | | |

Table 2c

Heat-Treating

| Run No. | Partial Pressure of Oxygen ($P_{O_2}$, bar) | Heat-Treating Temperature (Th, °C) | Heat-Treating Period (hour) |
|---|---|---|---|
| 2-1 | 5 | 920 | 5 |
| 2-2 | 5 | 930 | 5 |
| 2-3 | 5 | 920 | 3 |
| 2-4 | 2 | 910 | 5 |
| 2-5 | 5 | 890 | 5 |
| 2-6 | 5 | 890 | 10 |
| 2-7 | 10 | 910 | 5 |
| 2-8 | 10 | 920 | 5 |
| 2-9 | 5 | 900 | 10 |
| 2-10 | Same as 2-3 above | | |
| 2-11 | 2 | 920 | 3 |
| 2-12 | 0.2 | 930 | 5 |
| 2-13 | 0.2 | 920 | 5 |
| 2-14 | 0.2 | 920 | 10 |
| 2-15 | 0.2 | 930 | 10 |
| 2-16 | Same as 2-13 above | | |
| 2-17 | Same as 2-14 above | | |
| 2-18 | 0.2 | 880 | 5 |
| 2-19 | 0.2 | 890 | 5 |
| 2-20 | 0.2 | 900 | 10 |
| 2-21 | Same as 2-14 above | | |
| 2-22 | Same as 2-14 above | | |

Table 2d

| Characteristics of Superconducting Ceramics | | | |
|---|---|---|---|
| Run No. | Density ($\rho$s, g/cm$^3$) | Critical Temperature (Tc, °K) | Critical Current (Jc, A/cm$^2$) |
| 2-1 | 5.3 | 97 | 4900 |
| 2-2 | 5.1 | 92 | 4000 |
| 2-3 | 5.5 | 88 | 3700 |
| 2-4 | 5.4 | 90 | 4300 |
| 2-5 | 5.2 | 90 | 3700 |
| 2-6 | 5.3 | 89 | 2900 |
| 2-7 | 5.1 | 87 | 3700 |
| 2-8 | 5.4 | 89 | 4100 |
| 2-9 | 5.6 | 84 | 3900 |
| 2-10 | 5.4 | 91 | 4700 |
| 2-11 | 5.1 | 91 | 4400 |
| 2-12 | 3.9 | 96 | 170 |
| 2-13 | 4.0 | 91 | 210 |
| 2-14 | 4.1 | 87 | 330 |
| 2-15 | 4.0 | 89 | 150 |
| 2-16 | 3.9 | 90 | 100 |
| 2-17 | 3.7 | 89 | 290 |
| 2-18 | 4.1 | 86 | 310 |
| 2-19 | 4.0 | 87 | 260 |
| 2-20 | 4.0 | 83 | 300 |
| 2-21 | 3.6 | 91 | 290 |
| 2-22 | 2.5 | 91 | 170 |

Example 3

As starting powders are provided yttrium oxide ($Y_2O_3$) powder having a mean grain size of 6 $\mu$m, barium carbonate ($BaCO_3$) powder having a mean grain size of 6 $\mu$m, and copper oxide (CuO) powder having a mean grain size of 6 $\mu$m. These powders were blended at a blend ratio as follows:

$Y_2O_3$ : $BaCO_3$ : CuO = 1/2 : 2 : 3

and well mixed. The resulting mixed powder was calcined in the air at a temperature of 910 °C for 30 hours to produce a compound having a composition of $YBa_2Cu_3O_7$ and a perovskite structure. The compound was then pulverized to obtain superconducting ceramics powder having a mean grain size of 1.2 $\mu$m.

The superconducting ceramics were fabricated from the starting powder as above described in the same manner as the process in Example 2.

In the steps of sintering and heat-treating, molded bodies in the form of pellets were sintered under conditions as shown in Table 3a below and then heat-treated under conditions as shown in Table 3b below to obtain superconducting ceramics.

For comparison, the comparative superconducting ceramics were obtained by the same procedures as above except different conditions of the steps of sintering and heat-treating.

The density ($\rho$s), critical temperature (Tc) and critical current (Jc) of the superconducting ceramics thus obtained were measured and the results obtained are shown in Table 3c below.

From the results shown in Table 3c, it can be seen that the superconducting ceramics fabricated according to the process of the present invention, in which the partial pressure of oxygen when sintering was $10^{-2}$ to $10^{-10}$ bar ($10^{-2}$ to $10^{-10}$ atm) had high density and Jc values, and the superconducting ceramics fabricated according to the process of the present invention, in which the partial pressure of oxygen when heat-treating was 2 to 10 bar (2 to 10 atm), had density and Jc values much higher than that of the comparative superconducting ceramics.

Table 3a

Sintering

| Run No. | Partial Pressure of Oxygen ($P_{O_2}$, bar) | Sintering Temperature (Ts, $^{o}C$) | Sintering Period (hour) |
|---|---|---|---|
| 3-1 | $10^{-9}$ | 930 | 10 |
| 3-2 | $10^{-7}$ | Same as 3-1 above | |
| 3-3 | $10^{-5}$ | Same as 3-1 above | |
| 3-4 | $10^{-3}$ | Same as 3-1 above | |
| 3-5 | $10^{-2}$ | Same as 3-1 above | |
| 3-6 | 0.2 | Same as 3-1 above | |
| 3-7 | 1.0 | Same as 3-1 above | |
| 3-8 | 5.0 | Same as 3-1 above | |
| 3-9 | 10.0 | Same as 3-1 above | |
| 3-10 | $10^{-3}$ | Same as 3-1 above | |
| 3-11 | $10^{-2}$ | Same as 3-1 above | |

Table 3b

Heat-Treating

| Run No. | Partial Pressure of Oxygen ($P_{O_2}$, bar) | Heat-Treating Temperature (Th, °C) | Heat-Treating Period (hour) |
|---|---|---|---|
| 3-1 | 10 | 880 | 5 |
| 3-2 | 5 | 900 | 10 |
| 3-3 | 5 | 930 | 3 |
| 3-4 | 2 | 950 | 5 |
| 3-5 | 10 | 900 | 3 |
| 3-6 | 1 | 900 | 3 |
| 3-7 | Same as 3-6 above | | |
| 3-8 | - | - | - |
| 3-9 | - | - | - |
| 3-10 | 0.2 | 900 | 5 |
| 3-11 | 0.2 | Same as 3-10 above | |

Table 3c

| Characteristics of Superconducting Ceramics | | | |
|---|---|---|---|
| Run No. | Density ($\rho$s, g/cm$^3$) | Critical Temperature (Tc, °K) | Critical Current (Jc, A/cm$^2$) |
| 3-1 | 5.6 | 97 | 4400 |
| 3-2 | 5.7 | 96 | 5100 |
| 3-3 | 5.5 | 97 | 5200 |
| 3-4 | 5.6 | 98 | 4900 |
| 3-5 | 5.4 | 97 | 4700 |
| 3-6 | 4.5 | 96 | 720 |
| 3-7 | 4.3 | 94 | 650 |
| 3-8 | 3.8 | 95 | 270 |
| 3-9 | 3.4 | 95 | 300 |
| 3-10 | 4.9 | 94 | 690 |
| 3-11 | 4.6 | 95 | 580 |

Industrial Applicability

The present of this invention provides superconducting ceramics materials having not only improved superconducting characteristics such as high critical temperature and critical current.

**Claims**

1. A process for fabricating worked superconducting ceramics material composed essentially of an yttrium-including rare earth element, an alkaline earth metal, copper and balance oxygen and unavoidable impurities, comprising:
   (A) providing a starting powder composed of:
      (i) a member selected from the group consisting of:
         (1) a mixed powder composed of powders of the component oxides:
            (1-1) an yttrium-including rare earth element oxide,
            (1-2) an alkaline earth metal oxide, and
            (1-3) copper oxide,
         and having a composition substantially the same as that of a contemplated superconducting ceramics,
         (2) a mixed powder composed of powders of:
            (2-1) a partial compound between any two of the component oxides constituting a contemplated superconducting ceramics selected from (1-1), (1-2) and (1-3), and
            (2-2) the rest of the component oxides selected from (1-1), (1-2) and (1-3),
         and having a composition substantially the same as that of a contemplated superconducting ceramics,
         (3) a powder of a superconducting ceramics composed essentially of an yttrium-including rare earth element, an alkaline earth element, copper and balance oxygen and unavoidable impurities,
         (4) a mixed powder composed of at least two members selected from the mixed powders (1), (2) and (3); and
   (B) molding said starting powder to form a molded body;
   (C) optionally calcining said starting powder when said strating powder is said mixed powder (i)-(1), (i)-(2) or (i)-(3) at a temperature sufficient for calcining the starting powder prior to or after molding;
   (D) sintering said molded body in an oxygen-poor atmosphere having a partial pressure of oxygen of 10 to $10^{-7}$ mbar ($10^{-2}$ to $10^{-10}$ atm); and
   (E) heat-treating said sintered molded body in an oxygen-rich atmosphere having a partial pressure of oxygen above 1 bar (1 atm).

2. The process as claimed in Claim 1, wherein said oxygen-rich atmosphere has a partial pressure of oxygen of 2 to 10 atm.

3. The process as claimed in Claim 1, wherein said starting powder is mixed powder (1) and/or (2) and/or (4).

4. The process as claimed in Claim 3, wherein said starting powder is composed of the mixed powder (1).

5. The process as claimed in Claim 4, wherein said yttrium-including rare earth element oxide (1-1) is yttrium oxide.

6. The process as claimed in Claim 5, wherein said alkaline earth metal oxide (1-2) is barium oxide.

7. The process as claimed in Claim 1, wherein said starting powder is composed of the powder (3).

8. The process as claimed in Claim 7, wherein said yttrium-including rare earth element is yttrium.

9. The process as claimed in Claim 8, wherein said alkaline earth metal is barium.

10. The process as claimed in Claim 1, wherein said sintering is performed at a temperature of from 870 °C to 950 °C.

11. The process as claimed in Claim 1, wherein said heat-treatment is performed at a temperature of from 350 °C to 950 °C.

12. The process as claimed in Claim 1, further comprising cooling said sintered molded body after heat-treating, said cooling is performed at a cooling rate satisfying a relation expressed by an equation:

$$\Delta T/\Delta t \leq T \cdot \sqrt{P_{O_2}}$$

wherein

T indicates the temperature (°C) of the superconducting ceramics material,

t indicates the cooling time (hour), and

$$P_{O_2}$$

indicates the partial pressure of oxygen (atm) in a high temperature region at a temperature of not lower than 300 °C.

## Patentansprüche

1. Verfahren zur Herstellung eines verarbeiteten supraleitfähigen Keramikmaterials, das sich im wesentlichen aus einem Yttrium einschließenden Seltenerdelement, einem Erdakalimetall, Kupfer und einem Rest Sauerstoff und unvermeidliche Verunreinigungen zusammensetzt, das umfaßt:
   (A) Bereitstellen eines Ausgangspulvers, das sich zusammensetzt aus:
   (i) einem Glied, das aus der Gruppe ausgewählt ist, die besteht aus:
   (1) einem Mischpulver, das aus Pulvern der Komponentenoxide zusammengesetzt ist:
   (1-1) einem Yttrium einschließenden Seltenerdelementoxid,
   (1-2) einem Erdalkalimetalloxid, und
   (1-3) Kupferoxid,
   und das eine Zusammensetzung aufweist, die im wesentlichen die gleiche ist wie die der beabsichtigten supraleitfähigen Keramik,
   (2) einem Mischpulver, das aus den Pulvern zusammengesetzt ist aus:
   (2-1) einer Teilverbindung zwischen irgendwelchen zweien der Komponentenoxide, die eine beabsichtigte supraleitfähige Keramik bilden und die ausgewählt sind aus (1-1), (1-2) und (1-3) und
   (2-2) dem Rest der Oxidkomponenten, der ausgewählt ist aus (1-1), (1-2) und (1-3),
   und das eine Zusammensetzung aufweist, die im wesentlichen die gleiche ist wie die einer beabsichtigten supraleitfähigen Keramik,
   (3) einem Pulver einer supraleitfähigen Keramik, die im wesentlichen zusammengesetzt ist aus einem Yttrium einschließenden Seltenerdelement, einem Erdalkalielement, Kupfer und einem Rest Sauerstoff und unvermeidbare Verunreinigungen,
   (4) einem Mischpulver, das aus wenigsten 2 Gliedern zusammengesetzt ist, die aus den Mischpulvern (1), (2) und (3) ausgewählt sind; und
   (B) Verformung des genannten Ausgangspulvers unter Bildung eines geformten Körpers;
   (C) gegebenenfalls Calcinieren des genannten Ausgangspulvers, wenn das genannte Ausgangspulver das genannte Mischpulver (i)-(1), (i)-(2) oder (i)-(3) ist, bei einer Temperatur, die ausreicht, das Ausgangspulver zu calcinieren, und zwar vor oder nach dem Formen;
   (D) Sintern des genannten geformten Körpers in einer sauerstoffarmen Atmosphäre mit einem Sauerstoffpartialdruck von 10 bis $10^{-7}$ mbar ($10^{-2}$ bis $10^{-10}$ atm); und
   (E) Wärmebehandeln des genannten gesinterten Formkörpers in einer sauerstoffreichen Atmosphäre mit einem Sauerstoffpartialdruck von mehr als 1 bar (1 atm).

2. Verfahren nach Anspruch 1, bei dem die genannte sauerstoffreiche Atmosphäre einen Sauerstoffpartialdruck von 2 bis 10 atm aufweist.

3. Verfahren nach Anspruch 1, bei dem das genannte Ausgangspulver das Mischpulver (1) und/oder (2) und/oder (4) ist.

4. Verfahren nach Anspruch 3, bei dem das genannte Ausgangspulver von dem Mischpulver (1) gebildet wird.

5. Verfahren nach Anspruch 4, bei dem das genannte Yttrium einschließende Seltenerdelementoxid (1-1)

Yttriumoxid ist.

6. Verfahren nach Anspruch 5, bei dem das genannte Erdalkalimetalloxid (1-2) Bariumoxid ist.

7. Verfahren nach Anspruch 1, bei dem das genannte Ausgangspulver von dem Pulver (3) gebildet wird.

8. Verfahren nach Anspruch 7, bei dem das genannte Yttrium einschließende Seltenerdelement Yttrium ist.

9. Verfahren nach Anspruch 8, bei dem das genannte Erdalkalimetall Barium ist.

10. Verfahren nach Anspruch 1, bei dem das genannte Sintern bei einer Temperatur von 870 ° C bis 950 ° C durchgeführt wird.

11. Verfahren nach Anspruch 1, bei dem die genannte Wärmebehandlung bei einer Temperatur von 350 ° C bis 950 ° C durchgeführt wird.

12. Verfahren nach Anspruch 1, das außerdem das Abkühlen des genannten gesinterten Formkörpers nach der Wärmebehandlung umfaßt, wobei dieses Abkühlen in einem Hochtemperaturbereich auf eine Temperatur von nicht unterhalb 300 ° C mit einer Abkühlgeschwindigkeit durchgeführt wird, die eine Beziehung erfüllt, die durch die Gleichung ausgedrückt wird:

$$\Delta T/\Delta t \leqq T^{\bullet} \sqrt{P_O 2}$$

worin
T die Temperatur ( ° C) des supraleitfähigen Keramikmaterials bezeichnet,
t die Abkühlzeit (Stunden) bezeichnet, und
$P_{O2}$ den Sauerstoffpartialdruck (atm) bezeichnet.

## Revendications

1. Procédé de production d'une matière céramique supraconductrice usinée constituée essentiellement d'un élément faisant partie des terres rares, y compris l'yttrium, d'un métal alcalino-terreux, de cuivre, le reste étant formé par l'oxygène et les impuretés inévitables, consistant :
   (A) à préparer une poudre de départ constituée :
      (i) d'un membre du groupe comprenant :
         (1) une poudre mixte constituée de poudres des oxydes constitutifs :
            (1-1) un oxyde d'un élément faisant partie des terres rares, y compris l'yttrium,
            (1-2) un oxyde d'un métal alcalino-terreux, et
            (1-3) l'oxyde de cuivre,
         et ayant une composition pratiquement identique à celle d'une matière supraconductrice envisagée,
         (2) une poudre mixte constituée de poudres :
            (2-1) d'un composé partiel entre deux quelconques des oxydes constitutifs formant une matière céramique supraconductrice envisagée, choisis entre les oxydes (1-1), (1-2) et (1-3), et
            (2-2) du reste des oxydes constitutifs choisis entre (1-1), (1-2) et (1-3),
         et ayant une composition pratiquement identique à celle d'une matière céramique supraconductrice envisagée;
         (3) une poudre d'une matière céramique supraconductrice constituée essentiellement d'un élément faisant partie des terres rares, y compris l'yttrium, d'un élément alcalino-terreux, de cuivre, le reste étant formé par l'oxygène et les impuretés inévitables,
         (4) une poudre mixte constituée d'au moins deux membres choisis entre les poudres mixtes (1), (2) et (3) ; et
   (B) à mouler ladite poudre de départ pour former un corps moulé ;
   (C) à calciner facultativement ladite poudre de départ lorsque ladite poudre de départ consiste en ladite poudre mixte (i)-(1), (i)-(2) ou (i)-(3) à une température suffisante pour la calcination de la poudre de départ avant ou après moulage ;

(D) à fritter ledit corps moulé dans une atmosphère pauvre en oxygène, ayant une pression partielle d'oxygène de 10 à $10^{-7}$ mbars ($10^{-2}$ à $10^{-10}$ atm) ; et
(E) à soumettre ledit corps moulé fritté à un traitement thermique dans une atmosphère riche en oxygène, ayant une presion partielle d'oxygène supérieure à 1 bar (1 atm).

**2.** Procédé suivant la revendication 1, dans lequel l'atmosphère riche en oxygène possède une pression partielle d'oxygène de 2 à 10 atm.

**3.** Procédé suivant la revendication 1, dans lequel la poudre de départ est la poudre mixte (1) et/ou (2) et/ou (4).

**4.** Procédé suivant la revendication 3, dans lequel la poudre de départ est constituée de la poudre mixte (1).

**5.** Procédé suivant la revendication 4, dans lequel l'oxyde d'élément faisant partie des terres rares, y compris l'yttrium (1-1) est l'oxyde d'yttrium.

**6.** Procédé suivant la revendication 5, dans lequel l'oxyde de métal alcalino-terreux (1-2) est l'oxyde de baryum.

**7.** Procédé suivant la revendication 1, dans lequel la poudre de départ est constituée de la poudre (3).

**8.** Procédé suivant la revendication 7, dans lequel l'élément faisant partie des terres rares, y compris l'yttrium, est l'yttrium.

**9.** Procédé suivant la revendication 8, dans lequel le métal alcalino-terreux est le baryum.

**10.** Procédé suivant la revendication 1, dans lequel le frittage est effectué à une température de 870 ° C à 950 ° C.

**11.** Procédé suivant la revendication 1, dans lequel le traitement thermique est effectué à une température de 350 ° C à 950 ° C.

**12.** Procédé suivant la revendication 1, consistant en outre à refroidir le corps moulé fritté après traitement thermique, ledit refroidissement étant effectué à une vitesse de refroidissement satisfaisant à une relation exprimée par l'équation :

$$\Delta T/\Delta t \leq T \cdot \sqrt{P_{O_2}}$$

dans laquelle T désigne la température (° C) de la matière céramique supraconductrice,
t désigne le temps de refroidissement (heures), et

$$P_{O_2}$$

désigne la pression partielle d'oxygène (atm) dans une zone à haute température, à une température non inférieure à 300 ° C.